# FASCICULE DE BREVET EUROPEEN

(11) **EP 1 959 572 B1**
(45) Date de publication et mention de la délivrance du brevet: **15.08.2018**
(21) Numéro de dépôt: 08100852.6
(22) Date de dépôt: 24.01.2008
(51) Int. Cl.: H03M 13/11

(54) **Procédé de décodage à passage de messages et à convergence forcée**
Message-Passing-Dekodierverfahren mit forcierter Konvergenz
Decoding method with message passing and forced convergence

(30) Priorité: 13.02.2007 FR 0753228
(43) Date de publication de la demande: 20.08.2008
(73) Titulaire: Commissariat à l'Énergie Atomique et aux Énergies Alternatives, 75015 Paris (FR)
(72) Inventeur: Savin, Valentin, 38000 Grenoble (FR)
(74) Mandataire: Augarde, Eric

(56) Documents cités:
- US-A1- 2006 107 179
- STEFAN LANDNER OLGICA MILENKOVIC: "Algorithmic and Combinatorial Analysis of Trapping Sets in Structured LDPC Codes", WIRELESS NETWORKS, COMMUNICATIONS AND MOBILE COMPUTING, 2005 INTERNATI ONAL CONFERENCE ON MAUI, HI, USA 13-16 JUNE 2005, PISCATAWAY, NJ, USA,IEEE, vol. 1, 13 juin 2005 (2005-06-13), pages 630-635, XP010888030, ISBN: 978-0-7803-9305-9
- TORBEN BRACK ET AL: "DISCLOSING THE LDPC DECODER DESIGN SPACE", INTERNET CITATION, 10 mars 2006 (2006-03-10), XP002453148, Extrait de l'Internet: URL:http://www.eit.uni-kl.de/wehn/files/pu blikationen/2006/date06.pdf [extrait le 2007-09-28]
- J. HEO: "Performance and convergence analysis of improved MINSUMiterative decoding algorithm", IEICE TRANS. COMMUN., octobre 2004 (2004-10), XP008084238,
- JINGHU CHEN ET AL: "Transactions Papers<maths><tex>$\hrulefill$</tex></math s>Near Optimum Universal Belief Propagation BasedDecoding of Low-Density Parity Check Codes", IEEE TRANSACTIONS ON COMMUNICATIONS, IEEE SERVICE CENTER, PISCATAWAY, NJ, US, vol. 50, no. 3, mars 2002 (2002-03), XP011010136, ISSN: 0090-6778

## Description

### DOMAINE TECHNIQUE

La présente invention concerne le décodage de codes correcteurs d'erreurs dans le domaine des télécommunications ou de l'enregistrement de données. Plus précisément, l'invention est relative à une méthode de décodage itératif à passage de messages de codes correcteurs d'erreurs susceptibles d'une représentation par graphe bipartite, tels que les codes LDPC (*Low Density Parity Check*) ou les turbocodes.

### ÉTAT DE LA TECHNIQUE ANTÉRIEURE

Les codes correcteurs d'erreurs susceptibles de représentation par graphe bipartite recouvrent une large variété de codes, notamment les codes LDPC, initialement décrits par R. Gallager dans son article intitulé « Low density parity check codes » publié dans IEEE Trans. Inform. Theory, vol. IT-8, pages 21-28, 1962, dont les intéressantes propriétés ont été redécouvertes récemment, et les turbocodes introduits par C. Berrou et al. dans son article fondateur « Near optimum error correcting coding and decoding : turbocodes » paru dans IEEE Trans. Inform. Theory, vol. 44, N° 10, pages 1261-1271, 1996.

On appelle graphe bipartite un graphe non orienté dont l'ensemble des noeuds est constitué de deux sous-ensembles disjoints tels que deux noeuds quelconques d'un même sous-ensemble ne sont pas reliés entre eux par une arête du graphe.

Certains codes correcteurs d'erreurs sont susceptibles d'une représentation par graphe bipartite. Le graphe est partitionné en un premier sous-ensemble de noeuds associés aux symboles constituant un mot de code et un second sous-ensemble de noeuds associés aux contraintes du code, typiquement aux contrôles de parité. Un graphe bipartite associé à un groupe de contraintes est encore appelé graphe de Tanner.

Les symboles du mot de code sont en général des éléments du corps de Galois *F*₂={0,1}, autrement dit des bits, mais ils peuvent plus généralement être des éléments d'un corps de caractéristique 2 quelconque *F*_{2*^{p}*} et par conséquent d'un alphabet 2*^{p}*-aire. Dans la suite, nous nous limiterons sans perte de généralité au cas *p*=1, c'est-à-dire aux codes binaires.

Les codes susceptibles de représentation par graphe bipartite peuvent être décodés au moyen d'un décodage itératif à passage de messages, dit aussi de type MP (*Message Passing*) ou BP (*Belief Propagation*). On trouvera une description générique de cette méthode de décodage dans la thèse de N. Wiberg intitulée « Codes and decoding on general graphs », 1996. Le décodage itératif de type MP est en fait une généralisation d'algorithmes bien connus dans le domaine du décodage à savoir l'algorithme « forward-backward » utilisé pour les turbocodes et l'algorithme de Gallager pour les codes LDPC.

Dans un souci de simplification, nous rappellerons ci-après le principe du décodage itératif par passage de messages dans le cadre d'un code LDPC. Nous considérons un code linéaire (*K,N*) où *K* est la dimension du code représentant le nombre de bits d'information et *N* est la longueur du code, représentant le nombre de bits codés. *M* = *N - K* correspond au nombre de bits de parité ou, de manière équivalente, le nombre de contraintes de parité.

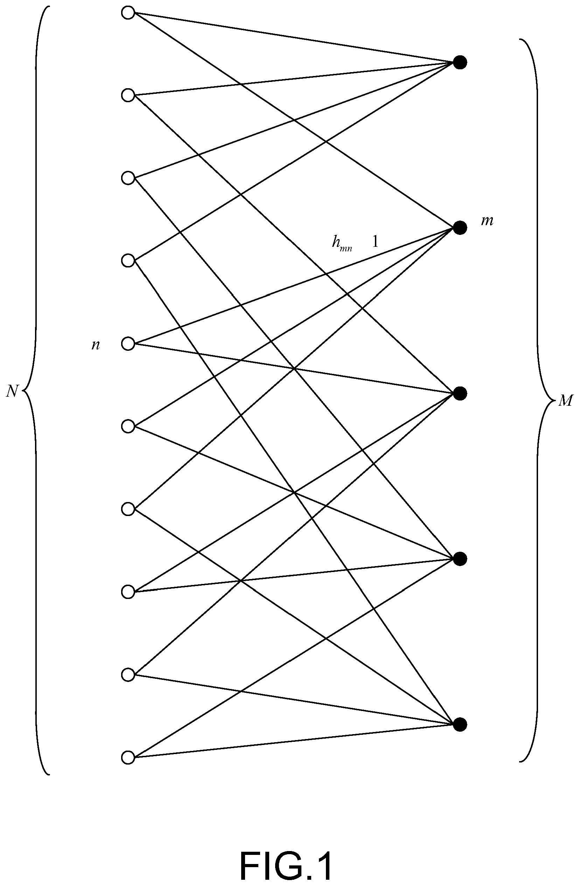

On a illustré en Fig. 1 le graphe de Tanner d'un code linéaire (*K,N*). On a fait figurer à gauche du graphe les noeuds correspondant aux bits du code, encore dénommés noeuds de type « variable » ou encore plus simplement « variables » et à droite les noeuds correspondant aux contrôles de parité, encore dénommés noeuds de type « contrôle » ou encore plus simplement « contrôles ». La matrice d'incidence du graphe correspond à la matrice de parité du code qui est de dimension *M*×N*.* Ainsi, le graphe bipartite comprend *N* noeuds de type « variable » et *M* noeuds de type « contrôle », un noeud *n* de variable étant relié à un noeud *m* de contrôle si et seulement si *hₘₙ* = 1. Par exemple, le graphe de la Fig. 1, correspond à un code (10,5) possédant la matrice de parité suivante : $H = \left(\begin{matrix}1 & 1 & 1 & 1 & 0 & 0 & 0 & 0 & 0 & 0 \\ 1 & 0 & 0 & 0 & 1 & 1 & 1 & 0 & 0 & 0 \\ 0 & 1 & 0 & 0 & 1 & 0 & 0 & 1 & 1 & 0 \\ 0 & 0 & 1 & 0 & 0 & 1 & 0 & 1 & 0 & 1 \\ 0 & 0 & 0 & 1 & 0 & 0 & 1 & 0 & 1 & 1\end{matrix}\right)$

On rappelle de manière générale qu'un code linéaire est défini par une matrice génératrice **G** dont les éléments sont des valeurs binaires et qu'un mot de code **x** = (*x*₁,*x*₂,..,*x_{N}*) est obtenu à partir d'un mot de bits d'information **a** = (*a*₁,*a*₂,...,*a_{K}*) au moyen de : $x = aG$ Puisque tous les mots de code vérifient les contrôles de parité, on a la relation : $H . {G}^{T} = 0$ où l'on a noté **G^{T}** la transposée de la matrice **G.**

Le mot de code **x** est transmis sur un canal de communication ou enregistré sur un support de données. A la réception ou à la lecture du support, on récupère une version bruitée de **x,** soit ***y*** = (*y*₁,*y*₂,...,y*_{N}*)*.* L'opération de décodage consiste à retrouver **x** et donc **a** à partir de l'observation **y.**

Nous conviendrons des notations suivantes avant de décrire le principe du décodage itératif à passage de messages :
*H*(*n*) désigne l'ensemble des contrôles reliés à la variable *n* dans le graphe bipartite, autrement dit l'ensemble des noeuds adjacents au noeud *n* ;
*H*(*m*) est l'ensemble des variables reliées au contrôle *m* dans le graphe bipartite, autrement dit l'ensemble des noeuds adjacents au noeud *m ;*
α*ₙ* représente l'information a *priori* concernant la variable *n* du graphe bipartite, autrement dit l'information a *priori* concernant le n^{ième} bit du mot de code. Cette information prend en compte le signal reçu et les caractéristiques du canal de transmission. Elle constitue l'entrée du décodeur et est généralement fournie par le démodulateur sous la forme de valeurs souples, soit en termes de probabilités : ${α}_{n} = \left({p}_{n}^{0} , {p}_{n}^{1}\right)$ où ${p}_{n}^{a} = Pr \left({x}_{n} = a | {y}_{n}\right) , a ∈ \left\{0,1\right\} ,$ soit, plus commodément, sous la forme d'un rapport logarithmique de probabilités, dit logarithme de rapport de vraisemblance ou LLR (*Log Likelihood Ratio) :* ${α}_{n} = ln \left(\frac{Pr \left({x}_{n} = 0 | {y}_{n}\right)}{Pr \left({x}_{n} = 1 | {y}_{n}\right)}\right)$ Ainsi, pour un bruit BBCG (bruit blanc centré gaussien) et une modulation BPSK, le démodulateur calcule simplement : ${α}_{n} = \frac{2}{{σ}^{2}} {y}_{n}$ où σ² est la variance du bruit.
α*ₘₙ* représente le message transmis par la variable *n* au contrôle *m*∈*H*(*n*)*.* Par référence aux turbocodes, α*ₘₙ* est encore appelée information extrinsèque ;
β*ₙₘ* représente de manière symétrique le message transmis par le contrôle *m* à la variable *n*∈*H*(*m*)*.* Il est également qualifié d'information extrinsèque ;
α̂*ₙ* représente l'information a *posteriori* relative à la variable *n* : elle prend en compte à la fois l'information *a priori* α*ₙ* et les messages β*ₙₘ* reçus par la variable *n* de ses contrôles adjacents pendant le décodage ;
α̅*ₙ* est la valeur dure correspondant à la valeur souple α̂*ₙ*, autrement dit la décision prise pour le bit *x*_{*n*.}

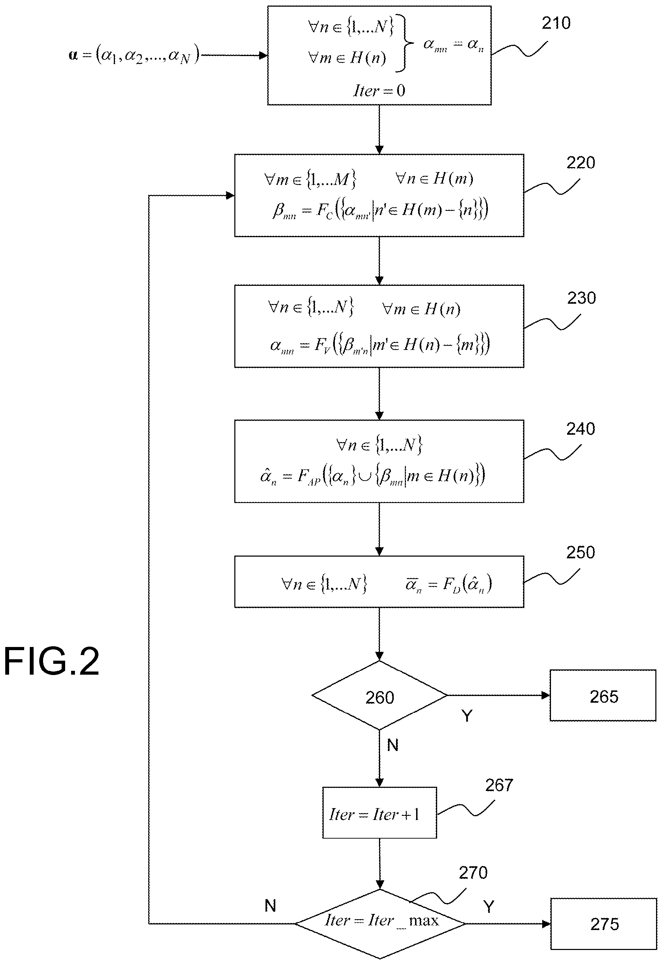

Le principe du décodage itératif par passage de messages est illustré en Fig. 2.

A l'étape 210, on procède à l'initialisation des messages α*ₘₙ*, pour chaque couple de variable *n* et de contrôle *m*∈*H*(*n*)*.* Les messages α*ₘₙ* sont généralement initialisés par les informations *a priori* c'est-à-dire : *αₘₙ*=α*ₙ,* ∀*m*∈*H*(*n*)*.* On initialise également le compteur d'itérations *Iter* à 0.

L'étape d'initialisation est suivie d'une boucle d'itération comprenant les étapes suivantes :
En 220, on procède au traitement des contrôles. Plus précisément, pour chaque contrôle *m*, on calcule les messages β*ₘₙ* du contrôle *m* à destination des variables respectives *n*∈*H*(*m*), soit : ${β}_{m n} = {F}_{C} \left(\left\{{α}_{m n '} | n ' ∈ H \left(m\right) - \left\{n\right\}\right\}\right)$ où l'on a noté *F_{C}* la fonction de traitement des contrôles. Pour un couple de noeuds *m,n*∈*H*(*m*) quelconque donné, le message β*ₘₙ* est calculé en fonction des messages qu'a lui-même reçu le contrôle *m* des variables *n*'∈*H*(*m*)-{*n*}*.* On constate par conséquent qu'il n'y a pas renvoi d'information extrinsèque d'un noeud de variable sur lui-même. L'étape de traitement des contrôles est aussi appelée étape horizontale.

En 230, on procède symétriquement au traitement des variables. Plus précisément, pour chaque variable *n,* on calcule les messages α*ₘₙ* à destination des contrôles respectifs *m*∈*H*(*n*)*,* soit : ${α}_{m n} = {F}_{V} \left(\left\{{β}_{m ' n} | m ' ∈ H \left(n\right) - \left\{m\right\}\right\}\right)$ où l'on a noté *F_{V}* la fonction de traitement des variables. Pour un couple de noeuds *n,m*∈*H*(*n*) donné, le message α*ₘₙ* est calculé en fonction des messages qu'a elle-même reçu la variable *n* des contrôles *m*'∈*H*(*n*)-{*m*}, de sorte que, comme précédemment, il n'y a pas renvoi d'information extrinsèque d'un noeud sur lui-même. L'étape de traitement des variables est aussi appelée étape verticale.

En 240, on estime l'information *a posteriori α̂ₙ* à partir de l'information *a priori* α*ₙ* et des messages β*ₘₙ* reçus par la variable *n* de la part de ses noeuds de contrôle adjacents *m*∈*H*(*n*)*,* ce que l'on exprime symboliquement par : ${\hat{α}}_{n} = {F}_{A P} \left(\left\{{α}_{n}\right\} ∪ \left\{{β}_{m n} | m ∈ H \left(n\right)\right\}\right)$ où l'on a noté *F_{AP}* la fonction d'estimation *a posteriori.*

En 250, on prend une décision sur les valeurs dures α̅*ₙ* à partir des valeurs souples α̂*ₙ*, soit : ${\overline{α}}_{n} = {F}_{D} \left({\hat{α}}_{n}\right)$ où l'on a noté *F_{D}* la fonction de décision. Typiquement, pour une modulation BPSK, la décision est prise sur le signe de la valeur souple, c'est-à-dire α̅*ₙ*=sgn(α̂*ₙ*). On identifiera dans la suite pour raison de commodité la valeur d'un bit avec sa valeur modulée. On représentera conventionnellement le bit « 0 » par la valeur « +1 » et le bit « 1 » par la valeur « -1 ».

En 260, on vérifie si le vecteur **α̅**=(α̅₁,α̅₂,..,α̅*_{N}*) est un mot de code, c'est-à-dire s'il satisfait aux contrôles de parité. Dans l'affirmative, on sort de la boucle en 265, le mot décodé étant **α̅**. Dans la négative, on incrémente le nombre d'itérations en 267 et on compare en 270, si le nombre d'itérations effectuées *Iter* a atteint une valeur de seuil *Iter*_max. Si ce n'est pas le cas, on poursuit le décodage itératif en rebouclant à l'étape 220. A défaut, on conclut à l'échec de l'opération de décodage et on sort en 275.

L'ordre des étapes dans la boucle d'itération peut différer de celui exposé en Fig. 2. En particulier, on peut intervertir l'ordre de traitement des variables et des contrôles et alors commencer par une initialisation des messages β*ₘₙ* : β*ₘₙ* = 0, ∀*n*∈{1,...*N*} et ∀*m*∈*H*(*n*)*.*

Selon le principe de décodage itératif présenté en Fig. 2, on procède au traitement de tous les contrôles puis de toutes les variables ou bien, comme mentionné ci-dessus, au traitement de toutes les variables puis de tous les contrôles. On parle alors d'«ordonnancement parallèle» ou encore d'«ordonnancement par inondation» (flooding scheduling). D'autres types d'ordonnancements ont été proposés dans la littérature ; ils peuvent être classés en deux catégories :
- ordonnancement de type série, catégorie dans laquelle on peut ranger les ordonnancements dénommés «serial scheduling», «shuffled-BP», «horizontal shuffled» ou «vertical shuffled». L'ordonnancement de type série est applicable aussi bien aux contrôles qu'aux variables. Pour une application aux contrôles, le décodage utilise la stratégie suivante :
   - on procède tout d'abord au traitement d'un seul contrôle *m* en calculant les messages β*ₘₙ* à destination des variables *n*∈*H*(*m*)*;*
   - on met à jour et on transmet les messages α_{*m*'*n*} de chaque variable *n*∈*H*(*m*) à destination des contrôles *m*'∈*H*(*n*)-{*m*}*.* On met également à jour les informations *a posteriori α̂ₙ* relatives à ces mêmes variables ;
   - on procède au traitement du contrôle suivant et l'on itère les deux étapes précédentes jusqu'à épuisement des contrôles.

De manière duale, on peut effectuer un traitement variable par variable au lieu d'effectuer un traitement contrôle par contrôle. Selon le cas envisagé, on parlera d'ordonnancement «horizontal shuffled» ou d'ordonnancement «vertical shuffled».

On peut aussi hybrider les deux ordonnancements précités sous la forme d'un ordonnancement dit «mixte» ou «group-shuffled». On trouvera une description de la stratégie de décodage correspondant à un ordonnancement mixte dans l'article de J. Zhang et al. intitulé «Shuffled iterative decoding» paru dans IEEE Trans. on Comm., Vol. 53, N° 2, Février 2005, pages 209-213. La stratégie est basée sur une partition des noeuds par groupes, le traitement étant en parallèle au sein d'un groupe et en série d'un groupe au suivant. Plus précisément, pour une partition en groupes de contrôles :
- on procède au traitement d'un premier groupe *G* formé par les contrôles {*m*₁,*m*₂,..,*m_{g}*} en calculant les messages β*_{mᵢn}* à destination des variables *n*∈*H*(*mᵢ*), pour *i*=1,...,*g ;*
- on met à jour et on transmet les messages α_{*m*'*n*} de chaque variable *n*∈*H*(*mᵢ*), *i*=1,...,*g* à destination des contrôles respectifs *m*'∈*H*(*n*)*-*{*mᵢ*}*.* On met également à jour les informations *a posteriori* α̂*ₙ* relatives à ces mêmes variables ;
- on procède au traitement du groupe de contrôles suivant et l'on itère les deux étapes précédentes jusqu'à épuisement des groupes de contrôles.

De manière duale, on peut opérer sur la base d'une partition par groupes de variables au lieu d'une partition par groupes de contrôles.

On connaît deux algorithmes principaux de décodage itératif à passage de messages pour les codes LDPC : l'algorithme SPA (*Sum Product Algorithm*), encore appelé «log-BP» et l'algorithme «Min-Sum», encore appelé «based BP». On trouvera une description détaillée de ces deux algorithmes dans l'article de W.E. Ryan intitulé «An introduction to LDPC codes», publié dans CRC Handbook for coding and signal processing for recording systems, et disponible sous le lien www.csee.wvu.edu/wcrl/ldpc.htm.

Les algorithmes SPA et Min-Sum ne diffèrent que par l'étape de traitement des contrôles qui sera détaillée plus loin. Les autres étapes sont identiques, à savoir :
L'étape 230 de traitement des variables consiste à calculer les messages α*ₘₙ* comme suit : ${α}_{m n} = ln \left(\frac{Pr \left({x}_{n} = 0 | {y}_{n} , {B}_{m n}^{*} , {C}_{m n}\right)}{Pr \left({x}_{n} = 1 | {y}_{n} , {B}_{m n}^{*} , {C}_{m n}\right)}\right)$ où ${B}_{m n}^{*}$ représente l'ensemble des messages *β*_{*m*'*n*} reçus par la variable *n* de la part des contrôles *m*'∈*H*(*n*)-{*m*} et *Cₘₙ* représente l'évènement correspondant à un contrôle de parité vérifié pour chacun de ces contrôles. Sous réserve de l'indépendance des *yₙ,* on montre que α*ₘₙ* peut s'exprimer sous forme de LLR par : ${α}_{m n} = {α}_{n} + {\sum }_{m ' ∈ H \left(n\right) - \left\{m\right\}} {β}_{m ' n}$
L'étape 240 d'estimation de l'information *a posteriori* consiste à calculer : ${\hat{α}}_{n} = ln \left(\frac{Pr \left({x}_{n} = 0 | {y}_{n} , {B}_{n} , {C}_{n}\right)}{Pr \left({x}_{n} = 1 | {y}_{n} , {B}_{n} , {C}_{n}\right)}\right)$ où *Bₙ* représente les messages reçus par la variable *n* de tous les contrôles de *H*(*n*) et *Cₙ* représente l'évènement correspondant à un contrôle de parité vérifié pour chacun de ces contrôles. Sous la même hypothèse que précédemment, on montre que α̂*ₙ* peut s'exprimer sous forme de LLR par : ${\hat{α}}_{n} = {α}_{n} + {\sum }_{m ∈ H \left(n\right)} {β}_{m n}$ On remarque d'après (12) et (14) que : ${α}_{m n} = {\hat{α}}_{n} - {β}_{m n}$ L'étape 230 de traitement des variables peut par conséquent être placée en fin d'itération, après l'estimation de l'information *a posteriori.* L'expression (15) traduit le fait que l'on ne retourne pas l'information extrinsèque (ici β*ₘₙ*) envoyée par un noeud (*m*) vers lui-même.

L'étape 250 de décision des valeurs dures est simplement réalisée par : ${\overline{α}}_{n} = sgn \left({\hat{α}}_{n}\right)$ où sgn(*x*)=1 si *x* est positif et sgn(*x*)=-1 sinon.

La vérification en 260 des contrôles de parité sur les valeurs dures passe par le calcul des contrôles de parité : ${c}_{m} = {\prod }_{n ∈ H \left(m\right)} {\overline{α}}_{n} , m = 1, … , M$

Les contrôles de parité sont tous satisfaits si et seulement si : ${\sum }_{m = 1}^{M} {c}_{m} = M$

L'étape de traitement des contrôles 220 consiste à calculer, pour l'algorithme SPA : ${β}_{m n} = ln \left(\frac{Pr \left({c}_{m} = 1 | {x}_{n} = 0, {A}_{m n}^{*}\right)}{Pr \left({c}_{m} = 1 | {x}_{n} = 1, {A}_{m n}^{*}\right)}\right)$ où *cₘ*=1 signifie une condition de parité satisfaite pour le contrôle *m* et ${A}_{m n}^{*}$ représente l'ensemble des messages α_{*mn*'}, reçus par le contrôle *m* de la part des variables *n*'∈*H*(*m*)-{*n*}. On montre que β*ₘₙ* peut s'exprimer par : ${β}_{m n} = \left({\prod }_{n ' ∈ H \left(m\right) - \left\{n\right\}} sgn \left({α}_{m n '}\right)\right) ⋅ Φ \left({\prod }_{n ' ∈ H \left(m\right) - \left\{n\right\}} Φ \left(| {α}_{m n '} |\right)\right)$ avec $Φ \left(x\right) = ln \left(\frac{{e}^{x} + 1}{{e}^{x} - 1}\right) = - ln \left(tanh \left(\frac{x}{2}\right)\right)$

Le traitement des contrôles selon l'algorithme Min-Sum correspond à une simplification de l'expression (20). Du fait de la décroissance rapide de la fonction Φ(*x*) et de l'égalité de Φ(*x*) avec sa réciproque, *i.e.* Φ(Φ(*x*))=*x*, on peut légitimement effectuer l'approximation suivante : ${β}_{m n} = \left({\prod }_{n ' ∈ H \left(m\right) - \left\{n\right\}} sgn \left({α}_{m n '}\right)\right) ⋅ {min}_{n ' ∈ H \left(m\right) - \left\{n\right\}} \left(| {α}_{m n '} |\right)$

L'algorithme de décodage Min-Sum est sensiblement plus simple que l'algorithme de décodage SPA car il n'effectue que des additions, comparaisons et changements de signe. De surcroît, les performances de l'algorithme Min-Sum sont indépendantes de l'estimation de la variance du bruit σ². En contrepartie, l'approximation des valeurs β*ₘₙ* selon l'expression (21), conduit à une perte de performances par rapport à l'algorithme de décodage SPA.

Bien que les performances de l'algorithme de décodage SPA soient effectivement meilleures que celles de l'algorithme Min-Sum, elles peuvent toutefois sévèrement se dégrader dans le cas d'une mauvaise estimation de la puissance de bruit.

Différentes versions modifiées de l'algorithme Min-Sum ont été proposées dans le but d'améliorer ses performances. Par exemple, l'article de W.E. Ryan précité fait intervenir un terme correctif dans l'approximation (21). Les performances de l'algorithme ainsi modifié se rapprochent de celles de l'algorithme SPA mais deviennent fortement dépendantes de l'erreur d'estimation de la puissance de bruit. En outre, le terme correctif accroît sensiblement la complexité du décodage. Cette version modifiée a été encore raffinée dans le document 3GPP TSG RAN WG1 #43 du 7 Novembre 2005, intitulé « Rate-compatible LDPC codes with low complexity encoder and decoder ». La méthode qui y est exposée consiste à n'apporter un terme correctif dans (21) que pour les δ valeurs α_{*mn*'} les plus faibles, c'est-à-dire celles plus contributives dans l'expression (20). Cet algorithme reste toutefois sensible à l'erreur d'estimation de la puissance de bruit. US 2006/0107179 propose une modification de l'algorithme Min-Sum qui consiste à réduire les valeurs extrinsèques en cas d'oscillation. L'objet général de la présente invention est de proposer un algorithme de décodage itératif de type à passage de messages permettant de décoder un code correcteur d'erreurs susceptible de représentation par graphe bipartite, possédant de meilleures performances en termes de taux d'erreur et de vitesse de convergence que l'algorithme Min-Sum, sans toutefois présenter la complexité et la sensibilité à l'estimation du bruit de l'algorithme SPA.

### EXPOSÉ DE L'INVENTION

La présente invention est définie par les revendications. Selon une première variante de réalisation, l'opération de réduction d'amplitude est une opération non linéaire. Par exemple, l'opération de réduction d'amplitude est une opération de seuillage de la valeur absolue de ladite information extrinsèque par rapport à une valeur de seuil. De préférence, la valeur de seuil est calculée de manière adaptative.

Selon un premier exemple de loi d'adaptation, la valeur de seuil est obtenue comme la valeur absolue de l'information extrinsèque transmise à l'itération précédente dudit noeud de variable au dit noeud de contrôle.

Selon un second exemple de loi d'adaptation, ladite valeur de seuil est obtenue comme la plus petite des valeurs absolues des informations extrinsèques transmises aux itérations précédentes dudit noeud de variable au dit noeud de contrôle.

Selon une seconde variante de réalisation, l'opération de réduction d'amplitude est une opération linéaire, par exemple une multiplication par un coefficient strictement positif et strictement inférieur à 1. Avantageusement, ledit coefficient est calculé de manière adaptative.

Selon un troisième exemple, l'opération de seuillage de l'information extrinsèque est suivie par une multiplication de l'information extrinsèque ainsi traitée par un coefficient strictement positif et strictement inférieur à 1.

Ladite information extrinsèque peut être calculée par ${α}_{m n}^{t e m p} = {\hat{α}}_{n} - {β}_{m n}$ où α̂*ₙ* est la valeur a *priori* de la variable associée au noeud de variable d'indice *n* et β*ₘₙ* est le message transmis par le noeud de contrôle d'indice *m* au noeud de variable d'indice *n.*

Le message β*ₘₙ* d'un noeud de contrôle d'indice *n* à un noeud de variable d'indice *m* peut être calculé par : ${β}_{m n} = \left({\prod }_{n ' ∈ H \left(m\right) - \left\{n\right\}} sgn \left({α}_{m n '}\right)\right) ⋅ {min}_{n ' ∈ H \left(m\right) - \left\{n\right\}} \left(| {α}_{m n '} |\right)$ où α_{*mn*'} désigne le message du noeud de variable d'indice *n*' au noeud de contrôle d'indice *m, H*(*m*) l'ensemble des noeuds de variable adjacents au noeud de contrôle d'indice *m,* sgn(*x*)=1 si *x* est positif et sgn(*x*)=-1 sinon.

L'invention concerne également un programme d'ordinateur comprenant des moyens logiciels adaptés à mettre en oeuvre les étapes de la méthode de décodage exposée ci-dessus lorsqu'il est exécuté par un ordinateur.

### BRÈVE DESCRIPTION DES DESSINS

La Fig. 1 représente un exemple de graphe de Tanner pour un code (*K,N*) ;
La Fig. 2 illustre de manière schématique le principe d'un décodage itératif par passage de messages connu de l'état de la technique ;
La Fig. 3 illustre schématiquement la méthode de décodage itératif par passage de messages selon un mode de réalisation de l'invention ;
La Fig. 4 indique le taux d'erreur obtenu par la méthode de décodage selon l'invention par comparaison aux méthodes de l'état de la technique, pour deux codes LDPC particuliers.

### EXPOSÉ DÉTAILLÉ DE MODES DE RÉALISATION PARTICULIERS

On considère à nouveau un code correcteur d'erreurs susceptible d'une représentation par un graphe bipartite avec *N* variables et *M* contrôles. Nous supposerons dans la suite, dans un but d'illustration et sans perte de généralité, que ce code correcteur est un code LDPC.

La présente invention repose sur la constatation suivante : lorsque les messages de variables, c'est-à-dire les valeurs d'information extrinsèque exprimées sous forme de LLR α*ₘₙ*, oscillent d'une itération à la suivante ou de manière générale lorsqu'elles reproduisent un schéma oscillatoire, l'algorithme Min-Sum ne converge pas ou ne converge que très lentement. Les oscillations de valeurs α*ₘₙ* sont généralement dues à la répartition du bruit dans le mot reçu. Le principe de l'invention est de contenir ces oscillations lorsqu'elles se produisent, de manière à forcer l'algorithme à entrer dans un régime de convergence.

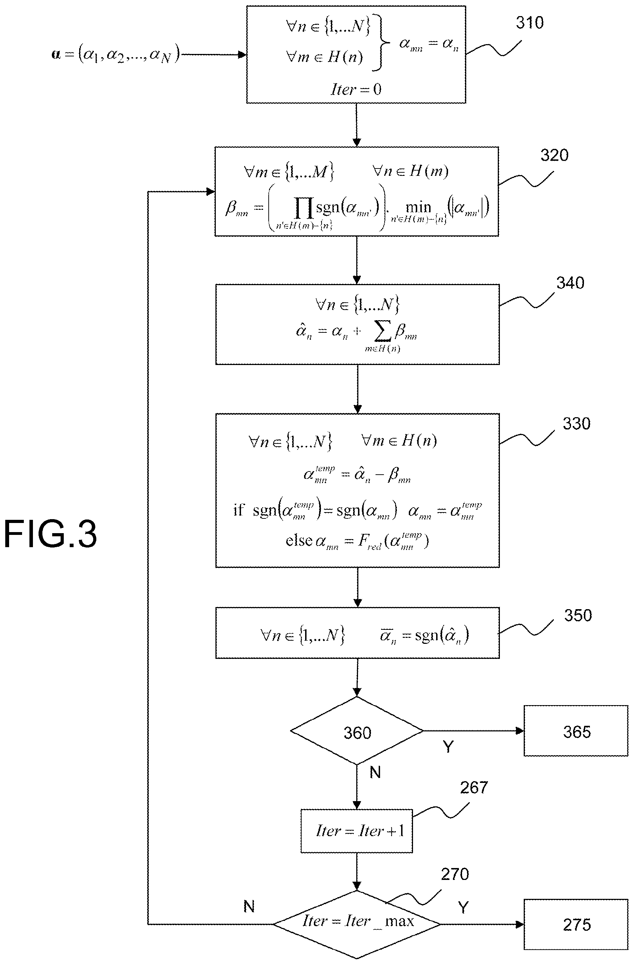

La Fig. 3 représente le procédé de décodage selon un mode de réalisation de l'invention. Les étapes 310, 360, 365, 367, 370 et 375 sont respectivement identiques aux étapes 210, 260, 265, 267, 270 et 275 de la Fig. 2. L'étape 320 correspond à l'étape 220 de la Fig. 2, dans laquelle on a explicité l'estimation des messages β*ₘₙ* selon l'algorithme Min-Sum, correspondant à l'expression (21). L'étape 340 correspond à l'étape 240 de la Fig. 2 dans laquelle on a explicité l'expression (14) des valeurs *a posteriori* α̂*ₙ*. Enfin, l'étape 350 correspond à l'étape 250 de la Fig. 2 dans laquelle on a explicité l'expression (16) de la fonction de décision.

On supposera que les valeurs d'information extrinsèque α*ₘₙ* sont rangées dans un tableau, ce tableau étant mis à jour à chaque itération.

L'étape 330 débute par un calcul des nouvelles valeurs extrinsèques sous forme de LLR à partir de l'expression (15) ${α}_{m n}^{t e m p} = {\hat{α}}_{n} - {β}_{m n} .$ Toutefois, à la différence du procédé de décodage Min-Sum classique, chaque valeur ainsi calculée est d'abord mémorisée comme valeur intermédiaire avant d'être traitée puis stockée dans le tableau des valeurs d'information extrinsèque. On notera que le traitement est effectué séquentiellement sur les valeurs de *n* et *m* en 330, de sorte qu'une seule variable intermédiaire est nécessaire.

Le signe de la valeur intermédiaire ${α}_{m n}^{t e m p}$ est comparé à celui de α*ₘₙ* déjà stocké, c'est-à-dire au signe de la valeur d'information extrinsèque obtenue à l'itération précédente et transmise comme message du noeud de variable *n* au noeud de contrôle *m* . Si ces signes sont identiques, $sgn \left({α}_{m n}^{t e m p}\right) = sgn \left({α}_{m n}\right) ,$ il n'y a pas d'oscillation, on rafraîchit α*ₘₙ* par ${α}_{m n} = {α}_{m n}^{t e m p}$ et on transmet cette valeur telle quelle au noeud de contrôle *m*.

En revanche, si les deux signes sont différents, $sgn \left({α}_{m n}^{t e m p}\right) = - sgn \left({α}_{m n}\right) ,$ le basculement de signe traduit un manque de fiabilité de la valeur ${α}_{m n}^{t e m p} .$ On tient compte de ce manque de fiabilité en réduisant l'amplitude de ${α}_{m n}^{t e m p} .$ On rafraîchit ensuite α*ₘₙ* avec la valeur ainsi obtenue, soit : ${α}_{m n} = {F}_{r e d} \left({α}_{m n}^{t e m p}\right)$ cette valeur étant transmise au noeud de contrôle *m*.

Selon une première variante de réalisation, l'opération de réduction d'amplitude $| {α}_{m n}^{t e m p} |$ est non linéaire, par exemple une opération de seuillage. La mise à jour des valeurs α*ₘₙ* s'effectue alors par : ${α}_{m n} = sgn \left({α}_{m n}^{t e m p}\right) . min \left(| {α}_{m n}^{t e m p} | , {α}_{m n}^{T}\right)$ où ${α}_{m n}^{T}$ est une valeur de seuil positive associée au noeud de variable *n* et au noeud de contrôle *m*. Avantageusement, les seuils ${α}_{m n}^{T} ,$ *1*≤*m*≤*M*, 1≤*n*≤*N* sont obtenus de manière adaptative. Plus précisément, ils sont initialisés (en 310) par les valeurs absolues des informations *a priori* soit ${α}_{m n}^{T} = | {α}_{n} |$ puis actualisés au moyen d'une loi d'adaptation.

Selon un premier exemple de loi d'adaptation, pour chaque couple de noeuds (*n,m*), la valeur de seuil de l'itération courante est égale à la valeur absolue de l'information extrinsèque de l'itération précédente, autrement dit le calcul de l'expression (23) est précédé par l'opération : ${α}_{m n}^{T} = | {α}_{m n} |$

Ainsi, en cas de basculement de signe, l'amplitude du message α*ₘₙ* de l'itération courante est limitée par la valeur absolue du message de l'itération précédente.

Selon un second exemple de loi d'adaptation, pour chaque couple de noeuds (*n,m*), la valeur de seuil de l'itération courante est égale à la plus petite valeur absolue des informations extrinsèques des itérations précédentes pour le même couple de noeuds, autrement dit, l'étape 330 comprend systématiquement une mise à jour du seuil, comme suit : $\begin{matrix}∀ n ∈ \left\{1, … N\right\} , ∀ m ∈ H \left(n\right) , \\ {α}_{m n}^{t e m p} = {\hat{α}}_{n} - {β}_{m n} \\ si sgn \left({α}_{m n}^{t e m p}\right) = sgn \left({α}_{m n}\right) alors {α}_{m n} = {α}_{m n}^{t e m p} \\ sinon {α}_{m n} = sgn \left({α}_{m n}^{t e m p}\right) . min \left(| {α}_{m n}^{t e m p} | , {α}_{m n}^{T}\right) \\ si | {α}_{m n} | < {α}_{m n}^{T} alors {α}_{m n}^{T} = | {α}_{m n} |\end{matrix}$

L'étape 330 peut être réalisée dans ce cas de manière équivalente par : $\begin{matrix}∀ n ∈ \left\{1, … N\right\} , ∀ m ∈ H \left(n\right) , \\ {α}_{m n}^{t e m p} = {\hat{α}}_{n} - {β}_{m n} \\ si | {α}_{m n}^{t e m p} | < {α}_{m n}^{M i n} alors {α}_{m n}^{M i n} = {α}_{m n}^{t e m p} \\ si sgn \left({α}_{m n}^{t e m p}\right) = sgn \left({α}_{m n}\right) alors {α}_{m n} = {α}_{m n}^{t e m p} \\ sinon {α}_{m n} = sgn \left({α}_{m n}^{t e m p}\right) . {α}_{m n}^{M i n}\end{matrix}$ où ${α}_{m n}^{M i n}$ est la plus faible amplitude des informations extrinsèques observées pour le couple de noeuds (*n,m*).

Selon une seconde variante de réalisation, l'opération de réduction d'amplitude est linéaire (en termes de LLR). Autrement dit, si un basculement de signe est détecté, l'amplitude de l'information extrinsèque est atténuée : ${α}_{m n} = λ {α}_{m n}^{t e m p}$ où λ est un coefficient tel que 0<λ<1. Avantageusement, on choisira pour des raisons d'implémentation λ=1-2^{-*b*} avec *b* entier strictement positif.

Le coefficient λ pourra être choisi adaptatif.

Selon une troisième variante de réalisation, l'opération de réduction d'amplitude pourra être la combinaison d'une opération linéaire et d'une opération non linéaire, par exemple une opération de seuillage et une opération d'atténuation comme décrites précédemment. La mise à jour des informations extrinsèques est alors réalisée en combinant (23) et (27) : ${α}_{m n} = sgn \left({α}_{m n}^{t e m p}\right) λ . min \left(| {α}_{m n}^{t e m p} | , {α}_{m n}^{T}\right)$

D'autres variantes de réalisation de l'opération de réduction d'amplitude, linéaires ou non linéaires, adaptatives ou non peuvent être également envisagées sans sortir du cadre de la présente invention. Parmi les opérations non linéaires on pourra notamment utiliser des fonctions sigmoïdales centrées sur l'origine.

L'invention a été décrite pour un ordonnancement parallèle commençant par les noeuds de contrôle. Il est cependant clair pour l'homme du métier qu'elle s'applique également à un ordonnancement parallèle commençant par les noeuds de variable. Elle s'applique aussi aux ordonnancements série et hybride tels que définis plus haut.

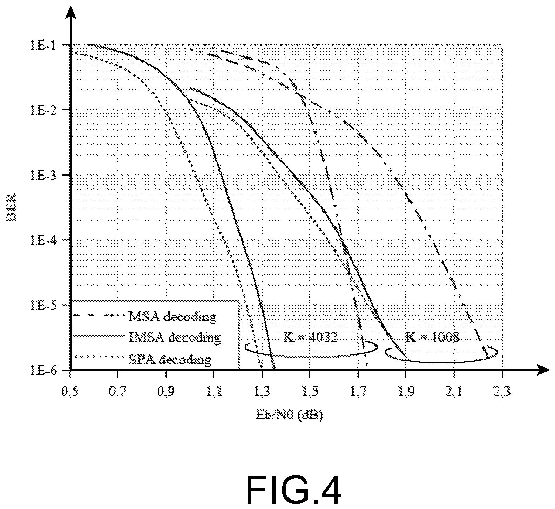

La Fig. 4 permet de comparer les performances en termes de taux d'erreurs (BER) des algorithmes Min-Sum et SPA conventionnels avec l'algorithme Min-Sum selon l'invention (IMSA), ce pour une plage importante de rapport signal à bruit. On a utilisé ici le second exemple de loi d'adaptation de la valeur de seuil, donnée par l'expression (26). Le nombre d'itérations effectuées est égal à 200 dans tous les cas. Les deux codes utilisés sont des codes LDPC irréguliers [1008,2016] et [4032,8064] donc de rendement 1/2. Le canal a été supposé AWGN (*Additive White Gaussian Noise*) et la modulation est QPSK.

On remarque que les performances de l'algorithme Min-Sum selon l'invention sont très proches de celles de l'algorithme SPA et ce pour une complexité comparable à celle de l'algorithme Min-Sum conventionnel.

La présente invention s'applique au décodage de codes correcteurs d'erreurs susceptibles de représentation par graphe bipartite, notamment des codes LDPC ou des turbocodes. Elle peut être utilisée dans le domaine de l'enregistrement de données ou des télécommunications, en particulier pour les systèmes de télécommunications utilisant déjà des codes LDPC, par exemple ceux obéissant aux normes IEEE 802.3a (Ethernet 10Gbits/s), DVB-S2 (diffusion de vidéo par satellite), IEEE 802.16 (WiMAX), ou susceptibles de les utiliser, par exemple les systèmes obéissant aux normes IEEE 802.11 (WLAN) et IEEE 802.20 (Mobile Broadband Wireless Access).

## Revendications

1. Méthode de décodage itératif de type à passage de messages pour décoder un code correcteur d'erreurs susceptible de représentation par un graphe bipartite comprenant une pluralité de noeuds de variable et une pluralité de noeuds de contrôle, lesdits messages étant exprimés en termes de logarithme de rapport de vraisemblance, **caractérisée en ce qu'**à chaque itération d'une pluralité d'itérations de décodage, pour chaque couple constitué d'un noeud de variable et d'un noeud de contrôle, on détecte un changement de signe de l'information extrinsèque destinée à être transmise $\left({α}_{m n}^{t e m p}\right)$ comme message par ledit noeud de variable au dit noeud de contrôle par rapport à celle transmise (*αₘₙ*) à l'itération précédente, et en cas de changement de signe, on soumet ladite information extrinsèque à une opération de réduction d'amplitude (*F_{red}*) avant de la transmettre au dit noeud de contrôle, l'opération de réduction d'amplitude étant une opération de seuillage de la valeur absolue de ladite information extrinsèque par rapport à une valeur de seuil $\left({α}_{m n}^{T}\right) ,$ ladite valeur de seuil étant obtenue comme la plus petite des valeurs absolues des informations extrinsèques transmises aux itérations précédentes dudit noeud de variable au dit noeud de contrôle.

2. Méthode de décodage selon la revendication 1, **caractérisée en ce que** l'opération de seuillage de l'information extrinsèque est suivie par une multiplication de l'information extrinsèque ainsi traitée par un coefficient strictement positif et strictement inférieur à 1.

3. Méthode de décodage selon la revendication 1 ou 2, **caractérisée en ce que** ladite information extrinsèque est calculée par ${α}_{m n}^{t e m p} = {\hat{α}}_{n} - {β}_{m n}$ où *α̂ₙ* est la valeur *a priori* de la variable associée au noeud de variable d'indice *n* et *βₘₙ* est le message transmis par le noeud de contrôle d'indice *m* au noeud de variable d'indice *n.*

4. Méthode de décodage selon l'une des revendications précédentes, **caractérisée en ce que** le message *βₘₙ* d'un noeud de contrôle d'indice *n* à un noeud de variable d'indice *m* est calculé par : ${β}_{m n} = \left({\prod }_{n ' ∈ H \left(m\right) - \left\{n\right\}} sgn \left({α}_{m n '}\right)\right) ⋅ {min}_{n ' ∈ H \left(m\right) - \left\{n\right\}} \left(| {α}_{m n '} |\right)$ où α*_{mn'}* désigne le message du noeud de variable d'indice *n*' au noeud de contrôle d'indice *m, H*(*m*) l'ensemble des noeuds de variable adjacents au noeud de contrôle d'indice *m,* sgn(*x*)=1 si *x* est positif et sgn(*x*)=-1 sinon.

5. Programme d'ordinateur comprenant des moyens logiciels adaptés à mettre en oeuvre les étapes de la méthode de décodage selon l'une des revendications précédentes, lorsqu'il est exécuté par un ordinateur.

## Patentansprüche

1. Iteratives Decodierverfahren vom Typ mit Message-Passing zum Decodieren eines fehlerkorrigierenden Codes, der zur Darstellung durch einen bipartiten Graphen geeignet ist, enthaltend eine Mehrzahl von Variablenknoten und eine Mehrzahl von Kontrollknoten, wobei die Nachrichten als logarithmisches Wahrscheinlichkeitsverhältnis ausgedrückt werden, **dadurch gekennzeichnet, dass** bei jeder Iteration aus einer Vielzahl von Decodieriterationen für jedes aus einem Variablenknoten und einem Kontrollknoten bestehende Paar ein Vorzeichenwechsel der extrinsischen Information, die dazu bestimmt ist, als Nachricht $\left({α}_{m n}^{t e m p}\right)$ von dem Variablenknoten an den Kontrollknoten übertragen zu werden, bezüglich derjenigen (*aₘₙ*), die bei der vorhergehenden Iteration übertragen wurde, erfasst wird, und im Falle eines Vorzeichenwechsels die extrinsische Information einer Amplitudenverringerungsoperation (*F_{red}*) unterzogen wird, bevor sie dem Kontrollknoten übertragen wird, wobei die Amplitudenverringerungsoperation eine Schwellenwertoperation des Absolutwertes der extrinsischen Information in Bezug auf einen Schwellenwert $\left({α}_{m n}^{T}\right)$ ist, wobei der Schwellenwert als der kleinste der Absolutwerte der extrinsischen Informationen erhalten wird, die bei den vorhergehenden Iterationen von dem Variablenknoten an den Kontrollknoten übertragen wurden.

2. Decodierverfahren nach Anspruch 1, **dadurch gekennzeichnet, dass** der Schwellenwertoperation der extrinsischen Information eine Multiplikation der so verarbeiteten extrinsischen Information mit einem strikt positiven und strikt kleineren Koeffizienten als 1 folgt.

3. Decodierverfahren nach Anspruch 1 oder 2, **dadurch gekennzeichnet, dass** die extrinsische Information berechnet wird mit ${α}_{m n}^{t e m p} = {\hat{a}}_{n} - {β}_{m n} ,$ worin *âₙ* der A-Priori-Wert der Variablen ist, die dem Variablenknoten mit dem Index *n* zugeordnet ist, und *βₘₙ* die Nachricht ist, die von dem Kontrollknoten mit dem Index *m* an den Variablenknoten mit dem Index *n* übertragen wird.

4. Decodierverfahren nach einem der vorangehenden Ansprüche, **dadurch gekennzeichnet, dass** die Nachricht *βₘₙ* von einem Kontrollknoten mit dem Index *n* an einen Variablenknoten mit dem Index *m* berechnet wird mit: ${β}_{m n} = \left({\prod }_{n ' ∈ H \left(m\right) - \left\{n\right\}} sgn \left({α}_{m n '}\right)\right) ⋅ {min}_{n ' ∈ H \left(m\right) - \left\{n\right\}} \left(| {α}_{m n '} |\right)$ worin *aₘₙ* die Nachricht vom Variablenknoten mit dem Index *n'* zum Kontrollknoten mit dem Index *m* bezeichnet, *H*(*m*) die Gesamtheit der dem Kontrollknoten mit dem Index *m* benachbarten Variablenknoten bezeichnet, wobei sgn(*x*) = 1, wenn *x* positiv ist, ansonsten sgn(*x*) = -1.

5. Computerprogramm mit Softwaremitteln, die dazu geeignet sind, die Schritte des Decodierverfahrens nach einem der vorangehenden Ansprüche durchzuführen, wenn es von einem Computer ausgeführt wird.

## Claims

1. Iterative decoding method of the message-passing type for decoding an error correcting code susceptible of representation by a bipartite graph including a plurality of variable nodes and a plurality of control nodes, said messages being expressed in terms of log likelihood ratio, **characterized in that** at each iteration of a plurality of decoding iterations, for each pair consisting of a variable node and a control node, a change is detected in the sign of the extrinsic information intended to be transmitted $\left({α}_{m n}^{t e m p}\right)$ as a message by said variable node to said control node relative to that transmitted (*αₘₙ*) at the previous iteration, and in the event of a sign change, said extrinsic information is subjected to an amplitude reduction operation (*F_{red}*) before it is transmitted to said control node, the amplitude reduction operation being an operation to threshold the absolute value of said extrinsic information relative to a threshold value $\left({α}_{m n}^{T}\right) ,$ said threshold value being obtained as the smallest of the absolute values of the extrinsic information transmitted at the previous iterations from said variable node to said control node.

2. Decoding method according to claim 1, **characterized in that** the operation to threshold the extrinsic information is followed by a multiplication of the extrinsic information so processed by a coefficient that is strictly positive and strictly less than 1.

3. Decoding method according to claim 1 or 2, **characterized in that** said extrinsic information is calculated by ${α}_{m n}^{t e m p} = {\hat{α}}_{n} - {β}_{m n}$ where *α̂ₙ* is the *a priori* value of the variable associated with the node with the index *n* and *βₘₙ* is the message transmitted by the control node with the index *m* to the variable node with the index *n* .

4. Decoding method according to one of the previous claims, **characterized in that** the message *βₘₙ* from a control node with the index *n* to a variable node with the index *m* is calculated by: ${β}_{m n} = \left({\prod }_{n ' ∈ H \left(m\right) - \left\{n\right\}} sgn \left({α}_{m n '}\right)\right) ⋅ {min}_{n ' ∈ H \left(m\right) - \left\{n\right\}} \left(| {α}_{m n '} |\right)$ where *α*_{*mn*'} denotes the message from the variable node with the index *n*' to the control node with the index *m, H*(*m*) is the set of the variable nodes adjacent to the control node with the index *m,* sgn(*x*)=1 if *x* is positive and sgn(*x*)=-1 otherwise.

5. Computer program including software means adapted to implement the steps in the decoding method according to one of the previous claims, when it is run on a computer.
